# EUROPÄISCHE PATENTSCHRIFT

(11) **EP 0 679 052 B1**
(45) Veröffentlichungstag und Bekanntmachung des Hinweises auf die Patenterteilung: **23.09.1998**
(21) Anmeldenummer: 95105976.5
(22) Anmeldetag: 21.04.1995
(51) Int. Cl.: H05K 3/18, C23C 18/16

(54) **Verfahren zur strukturierten Metallisierung der Oberfläche von Substraten**
Process for structured metallizing of the surface of substrates
Procédé de métallisation structurée de surfaces de substrats

(30) Priorität: 23.04.1994 DE 4414225
(43) Veröffentlichungstag der Anmeldung: 25.10.1995
(73) Patentinhaber: LPKF CAD/CAM SYSTEME GMBH, D-30827 Garbsen (DE)
(72) Erfinder: Kickelhain, Jörg, Dipl.-Ing., D-31535 Neustadt a. Rbge. (DE)
(74) Vertreter: Braun, Dieter, Dipl.-Ing.

(56) Entgegenhaltungen:
- EP-A- 0 180 101
- EP-A- 0 322 641
- WO-A-90/04911
- DE-A- 4 103 834
- PATENT ABSTRACTS OF JAPAN vol. 17, no. 344 (E-1390) 29. Juni 1993 & JP-A-05 048 244 (HITACHI AIC) 26. Februar 1993

## Beschreibung

Die Erfindung betrifft ein Verfahren zur strukturierten Metallisierung der Oberfläche von Substraten, insbesondere von Leiterplatten, gemäß dem Oberbegriff des Anspruchs 1.

Aus der DE 39 22 478 A1 ist bereits ein Verfahren der genannten Gattung bekannt geworden. Hier ist die Strukturierung kupferkaschierter Polymeroberflächen beschrieben. Mittels eines Excimerlasers erfolgt zwischen den Leiterbahnen ein Abtrag einer Kunststoffbeschichtung und einer Restkupferschicht. Wie sich gezeigt hat, führt hier jedoch die Tatsache, daß der Abtrag einer relativ dicken Kupferschicht mittels eines Excimerlasers mit einer Wärmeentwicklung verbunden ist, dazu, daß die für eine feine Strukturierung erforderlichen kantenscharfen Begrenzungen nicht zu erreichen sind. Das bedeutet, daß auf derartigen Oberflächen mittels eines Excimerlasers eine feine bzw. feinste Strukturierung von Leiterbahnen, wie sie immer häufiger erwünscht ist, nicht erzeugt werden kann. Außerdem ist der Abtrag einer relativ dicken Kupferschicht, wie sie eine Kupferkaschierung darstellt, mittels eines Excimerlasers sehr zeitaufwendig, so daß ein derartiges Verfahren in der Praxis nicht praktizierbar wäre. Im übrigen gilt auch dann, sofern nach dem Abtrag des Spiders mittels eines Excimerlasers ein galvanischer Leiterbahnaufbau erfolgt und anschließend ein Differenz-Ätzverfahren eingesetzt wird, daß eine feine bzw. feinste Strukturierung von Leiterbahnen nicht erzielbar ist. Mittels des Differenz-Ätzverfahrens sind kantenscharfe Begrenzungen in der erforderlichen Feinheit nicht herstellbar, da hier ein Unterätzen der Leiterbahnen unvermeidbar ist.

Insbesondere ist auch der bei den bekannten Verfahren erforderliche Einsatz eines Ätzmittels unter dem Gesichtspunkt des Umweltschutzes nicht optimal. Letzteres gilt insbesondere auch für die bekannten Verfahren, auf Leiterplatten photoempfindliche Schichten anzuordnen, in denen durch strukturierte Belichtung eine Reaktion abläuft, die nach dem Strippen ein Ätzen von Leiterbahnen mittels eines Ätzmittels ermöglicht.

In der Zeitschrift Galvano-Technik, 84 (1993), Nr. 2, Seiten 570 ff., ist andererseits in dem Artikel "Herstellung flexibler Schaltungen mit Bayprint - eine zukunftsweisende Technologie" ein Verfahren beschrieben, das ohne Belichtung und ohne Ätzung arbeitet. Hier wird eine Polymeroberfläche mit einem Primer, d. h. mit einer haftvermittelnden Schicht, im Siebdruckverfahren bedruckt. Die Leiterbahnstrukturen werden hier bereits durch eine strukturierte Beschichtung mit dem Primer vorgegeben. Der Primer ist nichtleitend, haftet gut auf der Polymeroberfläche und weist nach einem Trocknungsvorgang an einer Oberseite eine poröse Struktur auf, die anschließend eine hafffeste Verankerung einer stromlos abgeschiedenen Metallschicht ermöglicht. Die Metallschicht bildet dann die Leiterbahn. Dieses Verfahren weist zwar den Vorteil auf, daß es relativ einfach zu handhaben ist; der Nachteil liegt jedoch darin, daß durch das Siebdruckverfahren Grenzen hinsichtlich der erzielbaren Feinheit der Leiterbahnstruktur gegeben sind. Das beschriebene Verfahren eignet sich daher nicht zum Aufbringen sehr feiner Leiterbahnen, wie sie immer häufiger angestrebt werden. In dieser Druckschrift ist auf Seite 571, erster Absatz, auch bereits vorgeschlagen worden, Leiterplatten aus Polyimidwerkstoffen zur Durchkontaktierung mittels eines Excimerlasers mit Bohrungen zu versehen. Hier wird die an sich bekannte Tatsache genutzt, daß es sich bei dem Werkstoff Polyimid um ein homogenes Material handelt, das durch die hohe Photonen-Energie eines Excimerlasers gut abgetragen werden kann.

Durch die "PATENT ABSTRACTS OF JAPAN" vol.17, no344 (E-1390) 29. Juni 1993 & JP-A-05 048 ist auch bereits ein Verfahren der genannten Gattung bekannt geworden, bei dem die Deckschicht mit einer Dicke von wenigstens 50 µm aufgetragen wird und die mittels des Excimerlasers zu formende mögliche minimale Linienbreite des Stromkreises 50 µm beträgt.

Der Erfindung liegt die Aufgabe zugrunde, die genannten Nachteile zu vermeiden und ein Verfahren zu schaffen, das eine sehr hochauflösende strukturierte Metallisierung der Oberfläche von Substraten, insbesondere von Leiterplatten, schnell, wirtschaftlich und ohne Ätzvorgang ermöglicht.

Erfindungsgemäß wird diese Aufgabe durch die Merkmale des Anspruchs 1 gelöst. Die weitere Ausgestaltung der Erfindung ist den Unteransprüchen zu entnehmen.

Dadurch, daß die elektrisch nichtleitende Primerschicht Komponenten enthält, die beim späteren Aufbringen der Metallschicht chemisch reduktiv wirken und daß die Deckschicht in einer Dicke von 1 bis 20 µm aufgetragen wird, ist es möglich geworden, Leiterbahnen und Isolationskanäle mit höchster Konturenschärfe auf das Substrat aufzubringen. Unter Freilegung der Primerschicht werden in der dünnen Deckschicht feinste Strukturen mit einer Breite von nur bis zu etwa 0,3 µm erzeugt. Diese Strukturen weisen besonders ausgeprägte randscharfe und steile Flanken auf. Die von den Flanken geführt aufgebrachten Leiterbahnen weisen folglich gleichfalls randscharfe und steile Flanken auf.

Vorzugsweise erfolgt der Abtrag der Deckschicht mittels eines eines Krypton-Fluorid-Excimerlasers mit einer Wellenlänge von 248 nm. Insbesondere auch bei der Verwendung von Polyimidmaterialien findet dann der Abtrag der Deckschicht ohne jede Wärmeentwicklung statt, so daß auch aus diesem Grunde hier Strukturen mit extrem sauber und steil verlaufenden Flanken erzielbar sind. Es kommt zu keinerlei Aus- bzw. Aufschmelzerscheinungen an den Flanken der erzeugten Strukturen. Aus diesem Grunde kann dann auch der für die lsolationskanäle zwischen den Strukturen erforderliche Freiraum äußerst klein gehalten werden. Wesentlich ist es, daß der Abtrag, d. h. die Ablation, jeweils soweit durchgeführt wird, daß die Primerschicht völlig freigelegt ist. Hierbei ist es aber durchaus zulässig, daß auch die Primerschicht bis zu einer gewissen Reststärke abgetragen wird. Eine exakte Begrenzung der Eindringtiefe des Lasers ist also keineswegs erforderlich, was die Durchführung des Verfahrens vereinfacht und dessen Sicherheit erhöht.

Dadurch, daß erfindungsgemäß die abschließende Metallisierung innerhalb der erzeugten Strukturen durchgeführt wird, erfolgt stets ein von den Flanken der Deckschicht mit höchster Präzision exakt geführter Aufbau der Leiterbahnen etwa bis zur Oberfläche der Deckschicht, die vorzugsweise in einer Dicke aufgetragen ist, die der Dicke der vorgesehenen Metallisierung entspricht. Auch der bei herkömmlichen Metallisierungsverfahren auftretende sogenannte chemische Pilzwuchs kann hier aufgrund des an den Flanken geführten Aufbaus der Metallbelegung grundsätzlich nicht auftreten. Im Ergebnis können insbesondere beim Einsatz z. B. eines eines Krypton-Fluorid-Excimerlasers mit einer Wellenlänge von 248 nm problemlos Leiterbahnen und/oder lsolationskanäle mit höchster Auflösung, d. h. mit einer kleinsten Breite von bis zu etwa 0,3 µm bis 1 µm, aufgebracht werden. Hieraus ergibt sich u. a. auch die Möglichkeit, das erfindungsgemäße Verfahren sogar als Verdrahtungsverfahren im Chip-on-Board-, Chip-on-Flex- und im Smart-Card-Bereich einzusetzen.

Die Primerschicht kann direkt auf das Substrat mittels der an sich bekannten Verfahren wie Aufstreichen, Aufsprühen, Aufdrucken, Tauchen oder Abscheiden, haftfest aufgebracht werden. Vorzugsweise wird die Primerschicht als nichtleitende Paste auf das Substrat aufgetragen. Die Primerschicht enthält im übrigen Komponenten, die beim späteren Auftragen der Metallschicht chemisch reduktiv wirken. Eine derartige Ausbildung der Primerschicht ermöglicht ein stromloses Aufbringen der Metallschicht auf die durch das Strukturieren offengelegte Primerschicht zur Bildung von Leiterbahnen mit Hilfe eines reduktiven Bades, z. B. eines Cu-Bades.

Die Deckschicht wird vorzugsweise auf die Primerschicht in einer Dicke aufgetragen, die etwa gleich ist der Dicke der aufzubringenden Metallschicht, wobei diese in den Strukturen bis auf die Ebene der Oberfläche der sie umgebenden Deckschicht aufgebracht wird. Die Deckschicht ist dabei vorzugsweise von einem Polymer, insbesondere einem Polyimid oder einem Polyethylen, gebildet. Es ist aber durchaus denkbar, auch andere Materialien einzusetzen. Wesentlich ist es, daß das Material der Deckschicht mittels einer elektromagnetischen Strahlung im UV-Bereich in feinen Strukturen, unter Bildung von sauberen steilen Flanken abtragbar, elektrisch nichtleitend und in einem reduktiven Bad nicht metallisierbar ist. Es ist im übrigen auch möglich, die Deckschicht in Form eines Lackes auf Polymerbasis aufzubringen, der dann nach der Metallisierung der Strukturen strippbar ist. Die gebildeten Leiterbahnen ragen danach über die Oberfläche des Substrates hervor. Gegebenenfalls kann es vorteilhaft sein, wenn die Deckschicht von einem Polymer gebildet ist, das im Lötprozeß temperaturbeständig ist.

Gemäß einer bevorzugten Ausführungsform der Erfindung erfolgt der Abtrag der Deckschicht des Substrates unter Verwendung einer im Strahlengang angeordneten Maske oder mittels eines der an sich bekannten Abbildungs- oder Projektionsverfahren. Alternativ ist es möglich, die Deckschicht mittels eines fokussierten Laserstrahls abzutragen. Die genannten Verfahren ermöglichen es, den Laserstrahl bzw. das Licht sehr fein strukturiert und dosiert auf die Deckschicht einwirken zu lassen.

Ein Ausführungsbeispiel der Erfindung ist in der Zeichnung dargestellt und wird im folgenden näher beschrieben. Es zeigen:
Figur 1, einen Querschnitt durch eine Leiterplatte nach der Beschichtung mit der Primerschicht und der Deckschicht;
Figur 2, einen Querschnitt durch die Leiterplatte gemäß Figur 1, mit durch die Einwirkung eines Excimerlasers eingebrachten Strukturen;
Figur 3, einen Querschnitt durch die Leiterplatte gemäß den Figuren 1 und 2, mit einer in den Strukturen aufgebrachten Metallschicht.

In der Zeichnung ist mit 1 eine Leiterplatte bezeichnet, die in an sich bekannter Weise aus einem nichtleitenden Polymer besteht. Auf der Oberfläche der Leiterplatte 1 ist eine Primerschicht 2 in einer Stärke von etwa 2 µm bis 10 µm vollflächig aufgebracht. Das Aufbringen der Primerschicht 2 erfolgt z. B. durch Aufstreichen, Aufsprühen, Aufdrucken, Tauchen oder Abscheiden. Die Primerschicht 2 besteht beispielsweise nach der DE 37 4 3 780 A1 der Firma BAYER AG aus folgenden Komponenten:
0,03 - 4,00 Gew.-% einer katalytisch wirkenden Substanz als Aktivator,
3 - 40 Gew.-% eines Polyimides als Bindemittel,
1 - 30 Gew.-% eines Füllstoffes und
45 - 90 Gew.-% eines Lösungsmittels.

Die Leiterplatte 1 wird zusammen mit der aufgebrachten Primerschicht 2 bei einer Temperatur von ca. 250 °C eine Stunde lang getrocknet. Das Lösungsmittel bewirkt eine gute Haftung der Primerschicht 2 auf der Polymeroberfläche der Leiterplatte 1. Außerdem bildet sich beim anschließenden Trocknen der Primerschicht 2 an deren Oberfläche eine poröse Struktur aus. Diese poröse Struktur begünstigt die haftfeste Verankerung weiterer aufzubringender Beschichtungen. Die Primerschicht 2 enthält im übrigen Komponenten, die beim späteren Auftragen einer Metallschicht 3 chemisch reduktiv wirken. Diese Ausbildung der Primerschicht 2 ermöglicht ein späteres stromloses Aufbringen der Metallschicht 3 mit Hilfe eines reduktiven Bades.

Auf die Primerschicht 2 ist eine Deckschicht 4 aufgebracht, die vorzugsweise von einem Polyimid oder einem Polyethylen gebildet ist. Die Dicke der Deckschicht 4 entspricht der Dicke der später auf die freigelegte Primerschicht 2 aufzubringenden Metallschicht 3 und beträgt vorzugsweise etwa 5 bis 20 µm. Es ist möglich, die Deckschicht 4 in Form eines Lackes auf Polymerbasis aufzubringen, der dann nach der Metallisierung der Strukturen 6 strippbar ist. Die gebildeten Leiterbahnen ragen dann über die Oberfläche der Leiterplatte 1 hervor. Gegebenenfalls kann es vorteilhaft sein, wenn die Deckschicht 4 von einem Polymer gebildet ist, das im Lötprozeß temperaturbeständig ist.

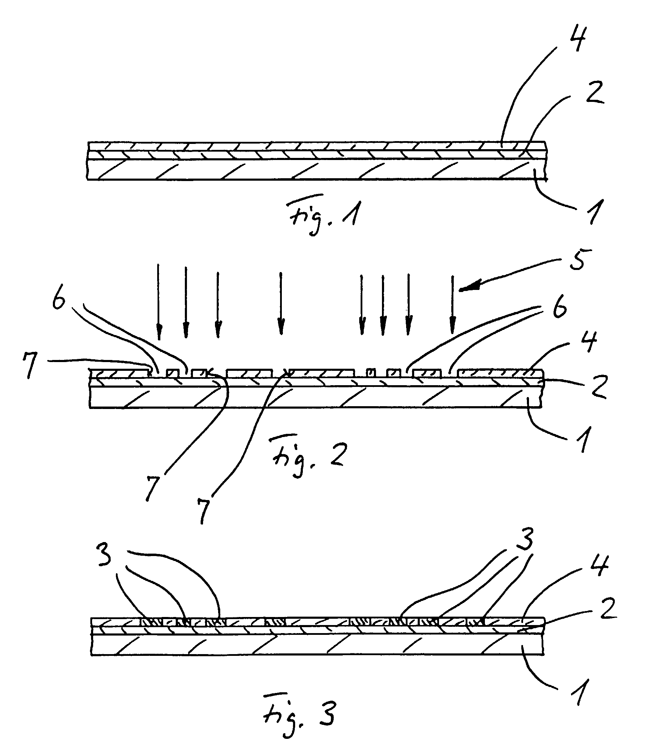

Aus der Figur 2 der Zeichnung ist ersichtlich, daß die Leiterplatte 1 partiell der Strahlung 5 eines in der Zeichnung nicht dargestellten Excimerlasers, vorzugsweise eines Krypton-Fluorid-Excimerlasers mit einer Wellenlänge von 248 nm, ausgesetzt wird. Grundsätzlich ist jedoch auch der Einsatz von Excimerlasern mit einen Wellenlänge von vorzugsweise 193 bis 308 nm möglich. Die Strahlung 5 bewirkt eine Ablation der Deckschicht 4 unter Ausbildung von Strukturen 6 mit scharfen und steilen Flanken 7. Wesentlich ist dabei, daß die Deckschicht 4 im Bereich der Strukturen 6 vollständig bis auf die Primerschicht 2 abgetragen wird. Hier wirkt es sich positiv aus, daß die Intensität der Einwirkung der Strahlung 5 des Excimerlasers auf die Deckschicht 4 über die Anzahl der Pulse sehr gut einreguliert werden kann. Da das Abtragsverhalten jedes einzelnen Laserimpulses bekannt ist, läßt sich die Deckschicht 4 im Bereich der Strukturen 6 sauber und völlig kantenscharf vollständig entfernen, wobei saubere, steile Flanken 7 entstehen. Es ist im übrigen jedoch durchaus zulässig, auch die Primerschicht 2 bis zu einer gewissen Reststärke abzutragen. Eine exakte Begrenzung der Eindringtiefe des Lasers ist also keineswegs erforderlich, was die Durchführung des Verfahrens vereinfacht.

Es ist übrigens zusätzlich auf einfache Weise gelungen, sicherzustellen, daß der eingesetzte Excimerlaser lediglich die Deckschicht 4 ablatiert und daß die für die nachfolgende Metallisierung wichtige Primerschicht 2 stets im wesentlichen erhalten bleibt. Dieses wird bereits aufgrund der unterschiedlichen Konsistenz der Primerschicht 2 und der darüber gelegten Deckschicht 4 erreicht, die aus einem leicht abtragbaren Polymer, vorzugsweise einem Polyimid oder Polyethylen, gebildet ist. Es ergeben sich somit günstige Abtragsverhältnisse an der Phasengrenze, zwischen den beiden Schichten 2 und 4. Es ist auf alle Fälle sichergestellt, daß der Excimerlaser die Deckschicht 4 vollständig entfernt. Die schwerer abtragbare, höher reflektierende Primerschicht 2 bleibt bei richtiger Wahl der Laserparameter stets im wesentlichen vollständig erhalten. Es kommt allenfalls lediglich im Bereich der oberen Phasengrenzschicht zu einem geringfügigen Abtrag. Insgesamt kann aus diesem Grunde die Primerschicht 2 mit allenfalls sehr geringer Schichtstärke aufgetragen werden. Es müssen lediglich die erforderliche Haftfähigkeit auf der Oberfläche der Leiterplatte 1 und eine vollständige Metallisierung sichergestellt sein. Im übrigen bildet die auf die Leiterplatte 1 aufgebrachte Primerschicht 2 eine ideale Basis für die Metallisierung.

Grundsätzlich wird bei der Ablation der Deckschicht 4 die Bindungsenergie des Materials durch die hohe Photonen-Energie, insbesondere der Excimerlaser-Strahlung, leicht aufgehoben, so daß ein äußerst schneller Materialabtrag ohne jede Erwärmung erfolgt. Dieses hat zur Folge, daß die Deckschicht 4 im Bereich des Materialabtrags außergewöhnlich scharf geschnitten wird. Es ist somit möglich, in der Deckschicht 4 feinste Strukturen 6 mit einer Breite von bis zu etwa 0,3 µm mit steilen Flanken 7 zu erzeugen. Als Folge läßt sich eine Metallschicht 3 mit einer Kantenschärfe und Kantensteilheit erzeugen, wie sie bisher nicht erzielbar war. Hierzu bedurfte es der Erkenntnis, daß es bei der Ablation der Deckschicht 4, unter Erzeugung scharfer und steiler Flanken 7, möglich ist, die gesamte Metallisierung exakt geführt durchzuführen. Das erfindungsgemäße Verfahren ist insbesondere auch dann vorteilhaft, sofern es bei höheren Stromstärken erforderlich ist, die Dicke der Metallschicht 3 zu erhöhen. Gerade hier wirkt sich ein präziser, senkrechter Verlauf der Flanken 7 besonders vorteilhaft aus. Dieses gilt insbesondere bei engen Leiterbahnabständen, d. h. bei einer hohen Polleiterzugdichte. Im übrigen besteht insbesondere bei Feinststrukturierungen der Bedarf, geringe Leiterzugbreiten zu erzeugen. Hieraus ergibt sich dann wiederum in der Regel die Notwendigkeit, insbesondere dann, wenn höhere Stromstärken zu erwarten sind, zum Ausgleich die Dicke der Metallschicht 3 zu erhöhen.

Wie aus der Figur 3 ersichtlich, wurde nach dem Aufbringen der Strukturen 6 auf das Substrat, d. h. auf die Leiterplatte 1, in die Strukturen 6 die Metallschicht 3 eingebracht. Die in diesen Bereichen frei gelegte Primerschicht 2 enthält Komponenten, die chemisch reduktiv wirken, so daß es möglich ist, die Metallschicht 3 stromlos, mit Hilfe des reduktiven Bades, aufzubringen. Eine derartige stromlose Metallisierung gewährleistet gleichmäßige Schichtstärken mit maximalen Abweichungen von etwa 0,2 µm. Die aufgebrachten Metallschichten 3 können also extrem dünn gehalten werden, wobei bereits bei Metallschichten 3 mit einer Stärke von kleiner als 1 µm gute elektrische Leitfähigkeiten erreicht werden. Somit ist das erfindungsgemäße Verfahren auch in der Dünnschichttechnik besonders vorteilhaft einsetzbar. Die geringe Gesamthöhe bringt Vorteile bei einem mehrschichtigen Aufbau.

Es ist bei dem beschriebenen erfindungsgemäßen Verfahren von Bedeutung, daß die Einwirkung der elektromagnetischen Strahlung, insbesondere auch beim Einsatz z. B. eines eines Krypton-Fluorid-Excimerlasers mit einer Wellenlänge von 248 nm, mit höchster Präzision erfolgt und daß dann die abschließende Metallisierung stets innerhalb der auf der Leiterbahn 1 erzeugten Strukturen 6 geführt durchgeführt wird. Dieses wird durch die erfindungsgemäße Anordnung der Primerschicht 2 unter der Deckschicht 4 ermöglicht. Es erfolgt dann ein von den randscharfen und steil verlaufenden Flanken 7 der Deckschicht 4 mit höchster Präzision exakt geführter Aufbau der Metallschicht 3. Die Leiterbahnen werden in der Regel bis zur Höhe der Oberfläche der Deckschicht 4 aufgetragen. Die Deckschicht 4 wird in einer Dicke aufgetragen, die der Dicke der vorgesehenen Metallisierung entspricht. Der bei herkömmlichen Metallisierungsverfahren auftretende sogenannte chemische Pilzwuchs kann hier aufgrund des von den Flanken geführten Aufbaus der Metallbelegung nicht auftreten. Da zudem auch die bei herkömmlichen Verfahren zum Teil unvermeidbare Unterätzung der Leiterbahnen sicher vermieden wird, können im Ergebnis problemlos Leiterbahnen und/oder Isolationskanäle mit höchster Auflösung, d. h. mit einer kleinsten Breite von bis zu etwa 0,3 µm bis 1 µm, aufgebracht werden. Hieraus ergibt sich u. a. die Möglichkeit, das erfindungsgemäße Verfahren sogar als Verdrahtungsverfahren im Chip-on-Board-, Chip-on-Flex- und Smart-Card-Bereich einzusetzen.

Es ist im übrigen von weiterem erheblichem Vorteil, daß mittels des erfindungsgemäßen Verfahrens auch räumliche elektronische Schaltungsträger, wie das Innere von Gerätegehäusen, in der beschriebenen Art und Weise mit Metallschichten 3 äußerst feiner Struktur versehen werden können. Dieses rührt daher, daß alle erforderlichen Verfahrensschritte auch an gewölbten Oberflächen problemlos durchführbar sind. Auf die Oberfläche auch eines stark gewölbten Substrates können die Primerschicht 2 und die Deckschicht 4 z. B. durch Aufsprühen durchaus hinreichend gleichmäßig aufgetragen werden. Die Einwirkung der Strahlung 5 des Excimerlasers kann beispielsweise über eine entsprechend geformte Schablone gleichfalls an beliebig gekrümmten Oberflächen von Substraten mit größter Präzision erfolgen. Nicht zuletzt bereitet der abschließende Auftrag der Metallschicht 3 in einem reduktiven Bad gleichfalls an gewölbten Oberflächen keine Schwierigkeiten. Das erfindungsgemäße Verfahren weist zusätzlich den Vorteil auf, daß keine Ätzmittel eingesetzt werden, so daß es sich um ein ausgesprochen umweltfreundliches Verfahren handelt. Die Strukturierung kann dabei nach der Installation der erforderlichen Vorrichtungen sehr kostengünstig durchgeführt werden.

## Patentansprüche

1. Verfahren zur strukturierten Metallisierung der Oberfläche von Substraten, insbesondere von Leiterplatten (1), unter Verwendung von elektromagnetischer Strahlung (5) eines Excimerlasers, wobei auf das Substrat (1) eine elektrisch nichtleitende Primerschicht (2) vollflächig aufgetragen wird und auf die Primerschicht (2) eine elektrisch nichtleitende Deckschicht (4) in einer Dicke vollflächig aufgetragen wird, die etwa gleich der Dicke einer aufzubringenden Metallschicht (3) ist, daß die Deckschicht (4) in Teilbereichen durch eine einwirkende Strahlung (5) eines Excimerlasers, unter Bildung von Strukturen (6) unter Freilegung der Primerschicht (2), abgetragen wird, und daß im Bereich der auf der Primerschicht (2) freigelegten Strukturen (6), von deren Flanken ( 7 ) geführt, in einem reduktiven Bad zur Bildung von Leiterbahnen, die Metallschicht (3) aufgebracht wird, wobei die elektrisch nichtleitende Primerschicht (2) Komponenten enthält, die beim späteren Aufbringen der Metallschicht (3) chemisch reduktiv wirken und die Deckschicht (4) in einer Dicke von 1 bis 20 µm aufgetragen wird.

2. Verfahren nach Anspruch 1, dadurch gekennzeichnet, daß die Deckschicht (4) in Teilbereichen durch die elektromagnetische Strahlung (5) Krypton-Fluorid-Excimerlasers mit einer Wellenlänge von 248 nm scharfkantig abgetragen wird.

3. Verfahren nach wenigstens einem der vorhergehenden Ansprüche, dadurch gekennzeichnet, daß die Metallschicht (3) bis auf die Höhe der Oberfläche der sie umgebenden Deckschicht (4) aufgebracht wird.

4. Verfahren nach wenigstens einem der vorhergehenden Ansprüche, dadurch gekennzeichnet, daß die Deckschicht (4) von einem Polymer, vorzugsweise einem Polyimid oder einem Polyethylen, gebildet ist.

5. Verfahren nach wenigstens einem der vorhergehenden Ansprüche, dadurch gekennzeichnet, daß die Deckschicht (4) von einem Polymer gebildet ist, das im Lötprozeß temperaturbeständig ist.

6. Verfahren nach wenigstens einem der vorhergehenden Ansprüche, dadurch gekennzeichnet, daß die gebildeten Leiterbahnen (Metallschicht 3) und/oder Isolationskanäle eine kleinste Breite von bis zu etwa 0,3 µm bis 1 µm aufweisen.

7. Verfahren nach wenigstens einem der vorhergehenden Ansprüche, dadurch gekennzeichnet, daß die Abtragung der Deckschicht (4) unter Verwendung einer in der elektromagnetischen Strahlung (5) angeordneten Maske bzw. mittels eines Abbildungs- oder Projektionsverfahrens erfolgt.

8. Verfahren nach wenigstens einem der vorhergehenden Ansprüche, dadurch gekennzeichnet, daß die Abtragung der Deckschicht (4) mittels einer fokussierten elektromagnetischen Strahlung (5) erfolgt.

9. Verfahren nach wenigstens einem der vorhergehenden Ansprüche, dadurch gekennzeichnet, daß die Abtragung der Deckschicht (4) mittels eines fokussierten Laserstrahls erfolgt.

10. Verfahren nach wenigstens einem der vorhergehenden Ansprüche, dadurch gekennzeichnet, daß die Primerschicht (2) auf das Substrat (Leiterplatte 1) durch Aufstreichen, Aufsprühen, Aufdrucken, Tauchen oder Abscheiden aufgebracht wird.

## Claims

1. A process for the structured metallising of the surface of substrates, especially of circuit boards (1), using electromagnetic radiation (5) from an excimer laser, whereby an electrically non-conducting primer layer (2) is applied over the whole surface of the substrate (1) and an electrically non-conducting covering layer (4) is applied onto the primer layer, covering the whole surface, to a thickness, which is approximately equal to the thickness of a metallic layer (3), which is to be deposited, that the covering layer (4) is ablated in partial areas by the effective radiation (5) of an excimer laser, forming structures (6) by the exposure of the primer layer (2), and that on the primer layer (2) in the region of the exposed structures (6), directed by their edges (7), the metallic layer (3) is applied in a reducing bath for the formation of conductor tracks, whereby the electrically non-conducting primer layer (2) includes components, which act chemically reductively during the later application of the metallic layer (3) and that the covering layer (4) is applied to a thickness of 1 to 20 µm.

2. A process according to Claim 1, characterised in that the covering layer (4) is removed in partial areas, providing sharp edges, by the electromagnetic radiation (5) of a krypton fluoride excimer laser with a wavelength of 248 nm.

3. A process in accordance with at least one of the foregoing Claims, characterised in that the metallic layer (3) is applied up to the level of the surface of the covering layer (4) which surrounds it.

4. A process in accordance with at least one of the foregoing Claims, characterised in that the covering layer (4) is formed from a polymer, preferably a polyimide or a polyethylene.

5. A process in accordance with at least one of the foregoing Claims, characterised in that the covering layer (4) is formed from a polymer, which can withstand the temperature of the soldering process.

6. A process in accordance with at least one of the foregoing Claims, characterised in that the conductor tracks formed (metallic layer 3) and/or the insulation channels have a least width of up to some 0.3 µm to 1 µm.

7. A process in accordance with at least one of the foregoing Claims, characterised in that the removal of the covering layer (4) is effected with the use of a mask arranged in the electromagnetic radiation (5) or using an imaging or projection process.

8. A process in accordance with at least one of the foregoing Claims, characterised in that the ablation of the covering layer (4) is effected by a focussed electromagnetic radiation (5).

9. A process in accordance with at least one of the foregoing Claims, characterised in that the ablation of the covering layer (4) is effected by a focussed laser beam.

10. A process in accordance with at least one of the foregoing Claims, characterised in that the primer layer (2) is applied to the substrate (Circuit board 1) by brushing, spraying, printing, dipping or deposition.

## Revendications

1. Procédé de métallisation structurée de la surface de substrats, en particulier de plaquettes de circuit imprimé (1), qui utilise les rayons électromagnétiques (5) émis par un laser à excimères, dans lequel une couche de base (2) non électroconductrice est déposée sur toute la surface du substrat (1) et une couche de recouvrement (4) non électroconductrice est déposée sur toute la surface de la couche de base (2) sur une épaisseur qui est pratiquement égale à l'épaisseur d'une couche de métal (3) à déposer, de sorte que la couche de recouvrement (4) est enlevée dans certaines parties sous l'effet des rayons (5) émis par un laser à excimères, en formant des structures (6) qui laissent apparaître la couche de base (2), et que dans la zone des structures (6) dégagées sur la couche de base (2), la couche de métal (3) est déposée, guidée par les flancs (7) desdites structures, dans un bain de réduction pour former des pistes conductrices, la couche de base (2) non électroconductrice contenant des composants qui exercent une action chimique réductrice pendant l'application ultérieure de la couche de métal (3) et la couche de recouvrement (4) étant déposée sur une épaisseur comprise entre 1 et 20 µm.

2. Procédé selon la revendication 1, caractérisé en ce que la couche de recouvrement (4) est enlevée partiellement en formant des arêtes vives, sous l'effet des rayons (5) électromagnétiques émis par un laser à excimères au krypton et fluorure avec une longueur d'onde de 248 nm.

3. Procédé selon au moins l'une des revendications précédentes, caractérisé en ce que la couche de métal (3) est déposée jusqu'à la hauteur de la surface de la couche de recouvrement (4) qui entoure ladite couche de métal.

4. Procédé selon au moins l'une des revendications précédentes, caractérisé en ce que la couche de recouvrement (4) est formée par un polymère, de préférence un polyimide ou un polyéthylène.

5. Procédé selon au moins l'une des revendications précédentes, caractérisé en ce que la couche de recouvrement (4) est formée par un polymère, qui résiste à la température pendant le processus de brasage.

6. Procédé selon au moins l'une des revendications précédentes, caractérisé en ce que les pistes conductrices (couche de métal 3) formées et/ou les canaux d'isolation présentent une largeur minimum comprise entre 0,3 µm et 1 µm.

7. Procédé selon au moins l'une des revendications précédentes, caractérisé en ce que l'enlèvement de la couche de recouvrement (4) est effectué à l'aide d'un masque posé pendant l'exposition aux rayons (5) électromagnétiques ou à l'aide d'un procédé de reproduction ou de projection.

8. Procédé selon au moins l'une des revendications précédentes, caractérisé en ce que l'enlèvement de la couche de recouvrement (4) est effectué à l'aide de rayons (5) électromagnétiques focalisés.

9. Procédé selon au moins l'une des revendications précédentes, caractérisé en ce que l'enlèvement de la couche de recouvrement (4) est effectué à l'aide d'un rayon laser focalisé.

10. Procédé selon au moins l'une des revendications précédentes, caractérisé en ce que la couche de base (2) est déposée sur le substrat (plaquette de circuit imprimé 1) par enduction, projection, application, immersion ou découpage.
